# EUROPEAN PATENT APPLICATION

(11) **EP 4 610 048 A1**
(43) Date of publication of application: **03.09.2025**
(21) Application number: 23882599.6
(22) Date of filing: 24.10.2023
(51) Int. Cl.: B32B 27/38, B32B 27/20, H05K 1/03

(54) **LAMINATED STRUCTURE, METHOD FOR PRODUCING SAME, CURED PRODUCT, AND ELECTRONIC COMPONENT**

(30) Priority: 24.10.2022 JP 2022169932; 08.06.2023 JP 2023095020
(71) Applicant: TAIYO HOLDINGS CO., LTD., Saitama 355-0222 (JP)
(72) Inventor: AOYAMA Yoshitomo, Hiki-gun, Saitama 355-0222 (JP); NAKA Yusuke, Hiki-gun, Saitama 355-0222 (JP); NAKADA Kazutaka, Hiki-gun, Saitama 355-0222 (JP)
(74) Representative: Hoffmann Eitle
(86) International application number: PCT/JP2023/038241
(87) International publication number: WO 2024/090394

(57) **Abstract**

The present invention provides a laminated structure capable of forming a cured product having a low roughness surface, excellent plating adhesion, and excellent heat resistance. The laminated structure of the present invention is a laminated structure comprising a first film and a resin layer provided on the first film, which is characterized by that the resin layer comprises (A) an epoxy resin, (B) a polyarylate compound having a bisphenol structure and an ester group, (C) an inorganic filler, and (D) a solvent, the (C) inorganic filler is comprised in the resin layer in an amount of 38 to 82 % by mass on a solid amount basis, and the resin layer has a mass loss rate of 3.0 % by mass or less after heating the resin layer at a temperature of 100 °C. under atmospheric pressure for 20 minutes.

## Description

### BACKGROUND OF THE INVENTION

### FIELD OF THE INVENTION

The present invention relates to a laminated structure, and more specifically, to a laminated structure comprising a resin layer formed using a curable resin composition that can be suitably used for electronic components such as printed wiring boards, its producing method, a cured product thereof, and an electronic component.

### [Background technology]

As electronic devices become smaller and their performance improves, there is also a demand for multilayer printed wiring boards with more layers and higher densities in the build-up layers. As a result, additive and semi-additive methods, in which a conductive layer is formed on the surface of an insulating layer by plating, have become mainstream, and there is a demand for insulating layer materials that can ensure adhesion to the plated conductive layer.

Therefore, for example, in the application of interlayer insulating materials for electronic components, there is a demand for the use of a resin composition capable of forming a cured product having excellent adhesion to a plating layer. In response to such demands, for example, Patent Document 1 proposes a thermosetting epoxy resin composition capable of forming a roughened surface having excellent adhesion to a plating layer by adding to an epoxy resin a predetermined amount of an active ester compound having a naphthalene structure. In addition, as another embodiment of the thermosetting epoxy resin composition, an adhesive film for forming an insulating layer as a laminated structure comprising a resin layer consisting of a thermosetting epoxy resin composition has also been proposed.

### [Prior art document]

### [Patent document]

[Patent Document 1] JP 2014-47318 A

### SUMMARY OF THE INVENTION

### [Problem to be solved by the invention]

However, the thermosetting epoxy resin composition proposed in Patent Document 1 using an active ester compound having a naphthalene structure cannot form a cured product having a glass transition temperature of 180 °C. or higher, and heat resistance is insufficient. In order to improve heat resistance, the crosslink density of the cured product is generally increased as a means for increasing the glass transition temperature without changing the type of resin. The inventors of the present invention conducted various studies and found that, although increasing the blending ratio of the active ester compound having a naphthalene structure to increase the crosslink density increases the glass transition temperature and improves heat resistance, it also reduces plating adhesion.

Therefore, the main object of the present invention has been made in consideration of the above problems, and is to provide a laminated structure capable of forming a cured product having a low surface roughness, excellent plating adhesion, and excellent heat resistance. Another object of the present invention is to provide a method for producing the laminated structure, the cured product, and an electronic component.

### [Means for solving the problem]

As a result of further investigation, the inventors of the present invention found that the decrease of the surface roughness and plating adhesion of the cured product is also affected by the mass loss rate after heating the resin layer in the laminated structure under predetermined conditions. The present invention is based on these findings. That is, the summary of the present invention is as follows.
[1] A laminated structure comprising a first film and a resin layer provided on the first film, wherein
   the resin layer comprises
      (A) an epoxy resin;
      (B) a polyarylate compound having a bisphenol structure and an ester group;
      (C) an inorganic filler; and
      (D) a solvent;
   the (C) inorganic filler is comprised in the resin layer in an amount of 38 to 82 % by mass on a solid amount basis, and
   the resin layer has a mass loss rate of 3.0 % by mass or less after heating the resin layer at a temperature of 100 °C. under atmospheric pressure for 20 minutes.
[2] The laminated structure according to [1], wherein the resin layer has a mass loss rate of 2.0 % by mass or less after heating the resin layer at a temperature of 100 °C. for 20 minutes.
[3] The laminated structure according to [1] or [2], wherein the resin layer is substantially free of a photopolymerization initiator and a photopolymerizable compound.
[4] A method for producing the laminated structure according to any one of [1] to [3], which comprises:
   a step of preparing a curable resin composition comprising (A) an epoxy resin, (B) a polyarylate compound having a bisphenol structure and an ester group, (C) an inorganic filler and (D) a solvent, wherein the inorganic filler is comprised in the resin layer in an amount of 38 to 82 % by mass on a solid amount basis;
   a step of applying the curable resin composition to one surface of a first film to form a coating film; and
   a step of drying the coating film at a temperature of 60 to 180 °C. for 1 to 30 minutes to form a resin layer.
[5] A cured product of the resin layer of the laminated structure according to any one of [1] to [3].
[6] An electronic part comprising the cured product according to [5].

According to the present invention, it is possible to achieve a laminated structure capable of forming a cured product having a low roughness surface, excellent plating adhesion, and excellent heat resistance by adjusting a mass loss rate of a resin layer in the laminated structure comprising an epoxy resin, a polyarylate compound having a bisphenol structure and an ester group, a predetermined amount of an inorganic filler, and a solvent to 3.0 % by mass or less after heating the resin layer under predetermined conditions. Furthermore, according to the laminated structure of the present invention, it is possible to obtain a cured product having a surface roughness of less than 0.30 µm, or even less than 0.20 µm, a peel strength from plating of 3.0 N/cm or more, or even 3.5 N/cm or more, and a glass transition temperature of 180 °C. or more, or even 190 °C. or more.

### DETAILED DESCRIPTION OF THE INVENTION

### <Laminated structure>

The laminated structure of the present invention comprises a first film and a resin layer provided on the first film, wherein the resin layer comprises (A) an epoxy resin, (B) a polyarylate compound having a bisphenol structure and an ester group, a predetermined amount of (C) an inorganic filler, and (D) a solvent. The resin layer constituting the laminated structure is formed by applying a curable resin composition comprising the above components to one side of the first film to form a coating film, and typically drying the coating film at a temperature of 60 to 180 °C. for 1 to 30 minutes. In the present invention, the resin layer formed has a mass loss rate (that is, (Mass of resin layer before heating - Mass of resin layer after heating) / Mass of resin layer before heating × 100) of 3.0 % by mass or less after heating the resin layer at a temperature of 100 °C. under atmospheric pressure for 20 minutes. In this way, by forming a resin layer comprises a predetermined amount of an inorganic filler and has a mass loss rate of 3.0 % by mass or less after heating, a laminated structure capable of obtaining a cured product having a low roughness surface, excellent plating adhesion, and excellent heat resistance can be obtained. That is, it is considered that the volatile components comprised in the resin layer become a curing inhibitor under certain conditions, and by adjusting the mass loss rate after heating to 3.0 % by mass or less in the resin layer comprising a predetermined amount of inorganic filler as in the present invention, the curing reaction proceeds moderately, and the effect of the present invention is preferably obtained. A trace conten of solvent, silane coupling agent, etc. are considered as the volatile components. However, the above-mentioned mechanism is merely the speculation by the inventors of the present invention, and is not necessarily bound by this theory.

The mass loss rate of the resin layer after heating can be adjusted by the material type and blending ratio of each component comprised in the curable resin composition described later, the drying temperature and drying time when forming the resin layer, etc. The mass loss rate after heating the resin layer at a temperature of 100 °C. for 20 minutes (hereinafter, sometimes simply referred to as "mass loss rate") is preferably 2.5 % by mass or less, more preferably 2.0 % by mass or less. In addition, the lower limit of the mass loss rate is more than 0 % by mass, since it is theoretically impossible for the resin layer of the laminated structure of the present invention to be 0 % by mass because it comprises the solvent (D), and may be, for example, 0.5 % by mass or more, or 1.0 % by mass or more. The curable resin composition for forming the resin layer will be described as follows.

### <Curable resin composition>

The resin layer constituting the laminated structure according to the present invention comprises, as essential components, (A) an epoxy resin, (B) a polyarylate compound having a bisphenol structure and an ester group, (C) an inorganic filler, and (D) a solvent. When the resin layer is heated, the (A) epoxy resin and the (B) polyarylate compound having a bisphenol structure and an ester group can react to form a cured product, and the resin layer is substantially free of a photopolymerization initiator and a photopolymerizable compound.

### [(A) Epoxy resin]

The resin layer constituting the laminated structure according to the present invention comprises an epoxy resin (A). As the epoxy resin, any thermosetting resin having an epoxy group in one molecule can be used without any particular limitation, and the epoxy equivalent is, for example, less than 2,000 g/eq. Examples of the epoxy resin (A) include bisphenol A type epoxy resin, bisphenol F type epoxy resin, hydrogenated bisphenol A type epoxy resin, brominated bisphenol A type epoxy resin, bisphenol S type epoxy resin, phenol novolac type epoxy resin, cresol novolac type epoxy resin, bisphenol A novolac type epoxy resin, biphenyl type epoxy resin, naphthol type epoxy resin, naphthalene type epoxy resin, dicyclopentadiene type epoxy resin, triphenylmethane type epoxy resin, alicyclic epoxy resin, aliphatic chain epoxy resin, phosphorus-containing epoxy resin, anthracene type epoxy resin, norbornene type epoxy resin, adamantane type epoxy resin, fluorene type epoxy resin, aminophenol type epoxy resin, aminocresol type epoxy resin, alkylphenol type epoxy resin and the like. These (A) epoxy resins may be used alone or in combination of two or more. The (A) epoxy resin preferably comprises at least one of bisphenol A type epoxy resin, bisphenol F type epoxy resin and biphenyl novolac type epoxy resin, and more preferably comprises bisphenol A type epoxy resin. By comprising bisphenol A type epoxy resin, the cured product has excellent heat resistance and excellent plating adhesion to a second film.

The (A) epoxy resin includes solid epoxy resins, semi-solid epoxy resins and liquid epoxy resins. The term "liquid" refers to a liquid state having fluidity at 20 °C., the term "semi-solid" refers to a solid state having no fluidity at 20 °C. but having fluidity at 40 °C., and the term "solid" refers to a solid state having no fluidity at 20 °C. and 40 °C.

Examples of the solid epoxy resin include epoxidized products of condensation products of phenols and aromatic aldehydes having a phenolic hydroxyl group (trisphenol type epoxy resins), such as EPPN-502H (trisphenol epoxy resin) manufactured by Nippon Kayaku Co., Ltd.; dicyclopentadiene aralkyl type epoxy resins, such as EPICLON (registered trademark) HP-7200H (dicyclopentadiene skeleton-containing polyfunctional solid epoxy resin) manufactured by DIC Corporation; biphenyl aralkyl type epoxy resins, such as NC-3000H and NC-3000L (biphenyl novolac type epoxy resin) manufactured by Nippon Kayaku Co., Ltd.; novolac type epoxy resins, such as EPICLON (registered trademark) N660 and EPICLON (registered trademark) N690 manufactured by DIC Corporation and EOCN-104S manufactured by Nippon Kayaku Co., Ltd.; and phenol novolac type epoxy resins, such as D.E.N. 431 manufactured by Dow Chemical Co., Ltd.; biphenyl type epoxy resins, such as YX-4000 manufactured by Mitsubishi Chemical Corporation; phosphorus-containing epoxy resins, such as TX0712 manufactured by Nippon Steel Chemical & Material Co., Ltd.; tris(2,3-epoxypropyl)isocyanurate, such as TEPIC manufactured by Nissan Chemical Industries, Ltd.; and bisphenol A type epoxy resins, such as jER (registered trademark) 1001 manufactured by Mitsubishi Chemical Corporation.

Examples of the semi-solid epoxy resin include bisphenol A type epoxy resins, such as EPICLON (registered trademark) 860, EPICLON (registered trademark) 900-IM, EPICLON (registered trademark) EXA-4816 and EPICLON (registered trademark) EXA-4822 manufactured by DIC Corporation, Epotohto YD-134 manufactured by Nippon Steel Chemical & Material Co., Ltd., jER (registered trademark) 834 and jER (registered trademark) 872 manufactured by Mitsubishi Chemical Corporation, and ELA-134 manufactured by Sumitomo Chemical Co., Ltd.; and phenol novolac type epoxy resins, such as EPICLON (registered trademark) N-740 manufactured by DIC Corporation.

Examples of the liquid epoxy resin include ZX-1059 (a mixture of bisphenol A type and bisphenol F type epoxy resins) manufactured by Nippon Steel Chemical & Material Co., Ltd., jER (registered trademark) 828 (bisphenol A type epoxy resin), jER (registered trademark) 807, and jER (registered trademark) 4004P (bisphenol F type epoxy resin) manufactured by Mitsubishi Chemical Corporation, EP-3300E (hydroxybenzophenone type liquid epoxy resin) manufactured by ADEKA Corporation, jER (registered trademark) 630 (aminophenol type liquid epoxy resin) manufactured by Mitsubishi Chemical Corporation, and ELM-100 (paraaminophenol type liquid epoxy resin) manufactured by Sumitomo Chemical Co., Ltd.

### [(B) Polyarylate compound having a bisphenol structure and an ester group]

The resin layer constituting the laminated structure according to the present invention comprises (B) a polyarylate compound having a bisphenol structure and an ester group, which also acts as a curing agent for the above-mentioned (A) epoxy resin. The (B) polyarylate compound having a bisphenol structure and an ester group is a polymer obtained by polycondensation of a divalent bisphenol component and a divalent aromatic carboxylic acid component.

As the divalent bisphenol component, any compound having two phenolic hydroxyl groups in one molecule can be used without any particular limitation, but a compound represented by the following formula (1) can be preferably used.

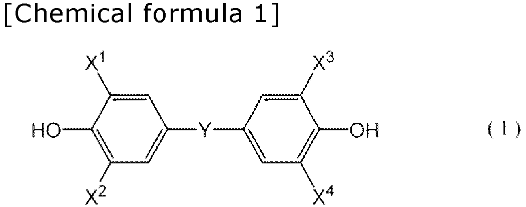

In the above formula (1), X¹ to X⁴ each independently represents a hydrogen atom, a hydrocarbon group having 1 to 12 carbon atoms, or a halogen atom, and Y represents a linear or branched alkylene group having 1 to 20 carbon atoms which may have a substituent. Examples of the substituent include cyclic hydrocarbon groups including aromatic and alicyclic groups, trihalomethane groups, alkyl ester groups and phenyl ester groups.

Among the above, the compound represented by the following formula (2) can be preferably used as the divalent bisphenol component.

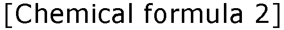

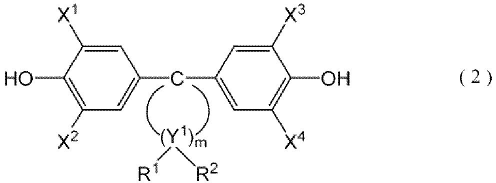

In the above formula (2), X¹ to X⁴ each independently represents a hydrogen atom, a saturated aliphatic hydrocarbon group having 1 to 12 carbon atoms, an unsaturated aliphatic hydrocarbon group having 2 to 6 carbon atoms, an aromatic hydrocarbon group having 6 to 10 carbon atoms or a halogen atom. When X¹ to X⁴ are saturated aliphatic hydrocarbon groups, they are preferably alkyl groups having 1 to 6 carbon atoms, and more preferably alkyl groups having 1 to 3 carbon atoms. Examples of the saturated aliphatic hydrocarbon group include a methyl group, an ethyl group, an n-propyl group, an isopropyl group, an n-butyl group, an isobutyl group, a t-butyl group, an n-pentyl group and an n-hexyl group. When X¹ to X⁴ are unsaturated aliphatic hydrocarbon groups, they are preferably alkenyl groups having 2 to 3 carbon atoms. Examples of the unsaturated aliphatic hydrocarbon group include a vinyl group and an allyl group. When X¹ to X⁴ are aromatic hydrocarbon groups, they are preferably aryl groups having 6 to 10 carbon atoms. Examples of the aromatic hydrocarbon group include a phenyl group and a naphthyl group. Examples of the halogen atom include a fluorine atom, a chlorine atom, a bromine atom and an iodine atom, with a chlorine atom and a bromine atom being preferred.

X¹ to X⁴ are preferably the same group. Furthermore, X¹ to X⁴ are preferably a hydrogen atom, an alkyl group having 1 to 6 carbon atoms, an aryl group having 6 to 10 carbon atoms, or a halogen atom.

In the above formula (2), Y¹ represents a carbon atom forming a saturated aliphatic hydrocarbon ring (monocyclic ring) together with the carbon atom to which the hydroxyphenyl group is bonded. The saturated aliphatic hydrocarbon ring represents a cycloalkane ring according to the value of m. Examples of the saturated aliphatic hydrocarbon ring include a cyclopentane ring (m=4), a cyclohexane ring (m=5) and a cycloheptane ring (m=6).

In the above formula (2), R¹ and R² each independently represents a hydrogen atom or a hydrocarbon group. The hydrocarbon group may be a saturated aliphatic hydrocarbon group having 1 to 4 carbon atoms, or an unsaturated aliphatic hydrocarbon group having 2 to 4 carbon atoms. The saturated aliphatic hydrocarbon group is preferably an alkyl group having 1 to 3 carbon atoms. Examples of the saturated aliphatic hydrocarbon group include a methyl group, an ethyl group, an n-propyl group, an isopropyl group, an n-butyl group, an isobutyl group and a t-butyl group. The unsaturated aliphatic hydrocarbon group is preferably an alkenyl group having 2 to 3 carbon atoms. Examples of the unsaturated aliphatic hydrocarbon group include a vinyl group and an allyl group. R¹ and R² are present in a plurality according to the value of m, and the plurality of R¹ and R² may each be independently selected from the above range, and are preferably a hydrogen atom or an alkyl group having 1 to 4 carbon atoms. In the above formula (2), m is an integer of 4 to 11, and is preferably 4 or 5.

The divalent aromatic carboxylic acid component can be used without any particular limitation as long as it is a compound having two carboxy groups directly bonded to an aromatic ring in one molecule, but terephthalic acid, isophthalic acid, orthophthalic acid, 4,4'-diphenyldicarboxylic acid, diphenyl ether-2,2'-dicarboxylic acid, diphenyl ether-2,3'-dicarboxylic acid, diphenyl ether-2,4'-dicarboxylic acid, diphenyl ether- 3,3'-dicarboxylic acid, diphenyl ether-3,4'-dicarboxylic acid, diphenyl ether-4,4'-dicarboxylic acid and 2,6-naphthalenedicarboxylic acid can be preferably used. The above-mentioned divalent aromatic carboxylic acid components may be used alone or in combination of two or more.

In the present invention, a polyarylate compound having a bisphenol structure and an ester group and represented by the following formula (3), which is obtained by polycondensing a divalent bisphenol component represented by the above formula (1) with terephthalic acid, isophthalic acid or orthophthalic acid as a divalent aromatic carboxylic acid component, may be used. In formula (3), X¹ to X⁴ and Y are the same as X¹ to X⁴ and Y in the above formula (1), and n represents a repeating unit.

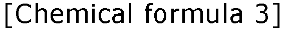

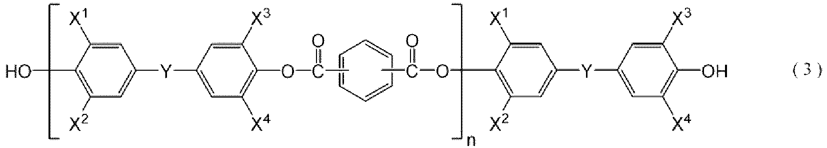

(B) a polyarylate compound having a bisphenol structure and an ester group can be obtained by polycondensing a divalent bisphenol component with a divalent aromatic carboxylic acid component. The polycondensation reaction is generally carried out using a polymerization catalyst under a reduced pressure of 130 Pa or less and at a temperature of 220 to 280 °C. Examples of the polymerization catalyst include titanium compounds such as tetrabutyl titanate; metal acetates such as zinc acetate, magnesium acetate and zinc acetate; antimony trioxide; and organic tin compounds such as hydroxybutyltin oxide and tin octoate.

The number average molecular weight of the (B) polyarylate compound having a bisphenol structure and an ester group obtained as described above is not particularly limited, but is, for example, 1,000 to 100,000. The number average molecular weight can be measured by gel permeation chromatography (GPC) according to a standard method.

The functional group equivalent of the (B) polyarylate compound having a bisphenol structure and an ester group (equivalent amount derived from the contents of the ester group and the phenolic hydroxyl group) is, for example, 150 to 350 g/eq.

The terminals of the (B) polyarylate compound having a bisphenol structure and an ester group may be blocked with a terminal blocking agent. A method for obtaining a terminal-blocked polyarylate compound can be a conventionally known method, for example, a method of mixing a divalent bisphenol component, a divalent aromatic carboxylic acid component and a terminal blocking agent, and polycondensing the mixture, or a method of polycondensing a divalent bisphenol component and a divalent aromatic carboxylic acid component, and then reacting with the terminal blocking agent.

Examples of the terminal blocking agent include monohydric phenols, monoacidic chlorides, monohydric alcohols and monocarboxylic acids. Examples of the monohydric phenol include phenol, o-cresol, m-cresol, p-cresol, p-tert-butylphenol [PTBP], o-phenylphenol, m-phenylphenol, p-phenylphenol, o-methoxyphenol, m-methoxyphenol, p-methoxyphenol, 2,3,6-trimethylphenol, 2,3-xylenol, 2,4-xylenol, 2,5-xylenol, 2,6-xylenol, 3,4-xylenol, 3,5-xylenol, 2-phenyl-2-(4-hydroxyphenyl)propane, 2-phenyl-2-(2-hydroxyphenyl)propane and 2-phenyl-2-(3-hydroxyphenyl)propane. Examples of the monoacid chloride include benzoyl chloride, benzoic acid chloride, methanesulfonyl chloride and phenyl chloroformate. Examples of the monohydric alcohol include methanol, ethanol, n-propanol, isopropanol, n-butanol, 2-butanol, pentanol, hexanol, dodecyl alcohol, stearyl alcohol, benzyl alcohol and phenethyl alcohol. Examples of the monocarboxylic acid include acetic acid, propionic acid, octanoic acid, cyclohexane carboxylic acid, benzoic acid, toluic acid, phenylacetic acid, p-tert-butylbenzoic acid and p-methoxyphenylacetic acid.

The (B) polyarylate compound having a bisphenol structure and an ester group may be a commercially available product, and examples thereof include Unifiner (registered trademark) M-2000H, M-2040, V-575 and W-575 (manufactured by Unitika Ltd.), and Zylon (registered trademark) 200H, 240V, 300H, 340V, 400H and 500H (manufactured by Asahi Glass Co., Ltd.), and these may be used alone or in combination of two or more.

The (B) polyarylate compound having a bisphenol structure and an ester group is preferably comprised in the resin layer of the laminated structure such that the ratio of the equivalent amount derived from the content of the epoxy group comprised in the (A) epoxy resin to the equivalent amount derived from the content of the ester group and the phenolic hydroxyl group comprised in the (B) polyarylate compound having a bisphenol structure and an ester group is 0.10 to 1.20, and more preferably the range of 0.30 to 1.00. The (B) polyarylate compound having a bisphenol structure and an ester group may be used alone or in combination of two or more.

### [(C) Inorganic filler]

The resin layer constituting the laminated structure according to the present invention comprises a predetermined amount of (C) inorganic filler in addition to the above-mentioned resin. In the present invention, as described above, a predetermined ratio of inorganic filler is comprised in the resin layer together with the (A) epoxy resin and the (B) polyarylate compound having a bisphenol structure and an ester group, and thereby the surface roughness of the cured product formed from the laminated structure can be reduced while the high levels of plating adhesion and heat resistance are simultaneously achieved. In the present invention, the (C) inorganic filler must be comprised in the resin layer of the laminated structure in an amount of 38 to 82 % by mass based on the solid amount, with a preferred content of 38 to 75 % by mass, and a more preferred content of 38 to 72 % by mass.

As the (C) inorganic filler, conventionally known ones can be used without any particular limitation, and examples thereof include non-metallic fillers such as silica, barium sulfate, calcium carbonate, silicon nitride, aluminum nitride, boron nitride, alumina, magnesium oxide, aluminum hydroxide, magnesium hydroxide, titanium oxide, mica, talc, barium titanate, clay, Neuburg silica particles, boehmite, magnesium carbonate, calcium zirconate and the like, and metallic fillers such as copper, gold, platinum, silver, palladium, silicon, alloys, ferrite, tin, zinc, nickel, aluminum, iron, cobalt and the like. The above-mentioned inorganic fillers may be used alone or in combination of two or more.

Among the (C) inorganic fillers, silica is preferably used from the viewpoint of decreasing the surface roughness of the cured product and simultaneously providing high levels of plating adhesion and heat resistance. Silica may be either amorphous or crystalline, or a mixture of these.

The shape of the (C) inorganic filler is not particularly limited, and examples thereof include spherical, needle-like, plate-like, scaly, hollow, irregular, hexagonal, cubic and flaky shapes.

The average particle size of the (C) inorganic filler is, for example, 0.1 µm to 25 µm, preferably 0.1 µm to 15 µm, and more preferably 1 µm to 10 µm, from the viewpoint of dispersibility and the like. The average particle size refers to the D50 value when the particle size distribution is prepared on a volume basis, and can be determined by a laser diffraction particle size distribution measuring device or a measuring device using a dynamic light scattering method. An example of a measuring device using the laser diffraction method is Microtrac MT3300EXII manufactured by Microtrac-Bell, and an example of a measuring device using the dynamic light scattering method is Nanotrac Wave II UT15 1 manufactured by Microtrac-Bell. The measurement sample in which the (C) inorganic filler is dispersed in PMA (propylene glycol monomethyl ether acetate) can preferably be used.

In addition, in consideration of the dispersibility and the like of the (C) inorganic filler, the surface of the inorganic filler may be subjected to a surface treatment. The surface treatment may be a surface treatment using a coupling agent or a surface treatment that does not introduce an organic group, such as an alumina treatment. The surface treatment method of the (C) inorganic filler is not particularly limited, and a conventionally known and commonly used method may be used, and the surface of the (C) inorganic filler may be treated with a surface treatment agent having a curable reactive group, for example, a coupling agent having a curable reactive group and the like.

The coupling agent may be a silane-based, titanate-based, aluminate-based, zircoaluminate-based coupling agent and the like. Among these, the silane-based coupling agent is preferably used. Examples of the silane coupling agent include vinyl silane-based coupling agents such as vinyl trimethoxysilane and vinyl triethoxysilane, amino silane coupling agents such as N-(2-aminomethyl)-3-aminopropyl methyl dimethoxysilane, N-(2-aminoethyl)-3-aminopropyl trimethoxysilane, 3-aminopropyl triethoxysilane, 3-anilinopropyl trimethoxysilane and N-phenyl-3-aminopropyl trimethoxysilane, epoxy silane-based coupling agents such as 3-glycidoxypropyl trimethoxysilane, 3-glycidoxypropyl methyl dimethoxysilane and 2-(3,4-epoxycyclohexyl)ethyl trimethoxysilane, (meth)acryloyl silane-based coupling agents such as 3-methacryloxypropyl trimethoxysilane, and mercapto silane-based coupling agents such as 3-mercaptopropyl trimethoxysilane, which may be used alone or in combination. These silane-based coupling agents are preferably immobilized in advance on the surface of the (C) inorganic filler by adsorption or reaction. The amount of the coupling agent to be used per 100 parts by mass of the inorganic filler is, for example, 0.1 to 10 parts by mass.

The curable reactive group is preferably a thermosetting reactive group. Examples of the thermosetting reactive group include a hydroxyl group, a carboxyl group, an isocyanate group, an amino group, an imino group, an epoxy group, an oxetanyl group, a mercapto group and an oxazoline group. Among these, at least one of an amino group and an epoxy group is preferable.

The surface-treated (C) inorganic filler may be comprised in the curable resin composition in a surface-treated state. That is, the inorganic filler and the surface treatment agent may be separately blended into the curable resin composition to treat the surface of the inorganic filler in the curable resin composition, but it is preferable to blend an inorganic filler that has been surface-treated in advance. By blending an inorganic filler that has been surface-treated in advance, it is possible to prevent a decrease in crack resistance and the like due to the surface treatment agent that was not consumed in the surface treatment, and which may remain when blended separately. When the surface treatment is performed in advance, it is preferable to blend a pre-dispersion solution in which the inorganic filler is pre-dispersed in a solvent or resin, and it is more preferable to pre-disperse the surface-treated inorganic filler in a solvent and then to blend the pre-dispersion into the composition, or to sufficiently treat the surface of the inorganic filler not yet subjected to the surface treatment when the it is pre-dispersed into a solvent, and then to blend the pre-dispersion solution into the composition.

The (C) inorganic filler may be blended with the epoxy resin and the like in a powder or solid state, or may be mixed with a solvent or a dispersant to form a slurry and then blended with the epoxy resin and the like. The (C) inorganic filler may be used alone or in combination of two or more.

### [Phenoxy resin]

The resin layer constituting the laminated structure according to the present invention may further comprise a phenoxy resin as a thermoplastic resin from the viewpoint of improving the mechanical strength of the cured product.

Examples of the phenoxy resin include phenoxy resins which are condensation products of epichlorohydrin and various bifunctional phenolic compounds, and phenoxy resins in which the hydroxyl groups of the hydroxyether moiety present in the skeleton are esterified using various acid anhydrides or acid chlorides, and have an epoxy equivalent of, for example, 2,000 g/eq. or more. Among these, phenoxy resins having a bisphenol skeleton are preferably used. The phenoxy resin has a bisphenol skeleton, which makes it possible to suitably obtain a cured product having a high glass transition temperature, high plating adhesion, and low surface roughness.

Specific examples of the phenoxy resin include FX280S and FX293 manufactured by Nippon Steel Chemical & Material Co., Ltd., and jER (registered trademark) YX8100BH30, jER (registered trademark) YX6954BH30, jER (registered trademark) YL6974, jER (registered trademark) YX7200B35 and jER (registered trademark) 1256B40 manufactured by Mitsubishi Chemical Corporation. The phenoxy resin may be used alone or in combination of two or more.

The blending ratio of the phenoxy resin is preferably 0.1 to 20 % by mass on a solid amount basis in the resin layer, and more preferably 1.0 to 10 % by mass. The phenoxy resin may be used alone or in combination of two or more.

### [Curing accelerator]

The resin layer constituting the laminated structure according to the present invention may comprise a curing accelerator in addition to the above-mentioned components. The curing accelerator can be used mainly to accelerate the reaction of the (A) epoxy resin and the (B) polyarylate compound having a bisphenol structure and an ester group.

Examples of the curing accelerator include a conventionally known curing accelerator such as imidazole derivatives such as imidazole, 2-methylimidazole, 2-ethylimidazole, 2-ethyl-4-methylimidazole, 2-phenylimidazole, 4-phenylimidazole, 1-cyanoethyl-2-phenylimidazole and 1-(2-cyanoethyl)-2-ethyl-4-methylimidazole; guanamines such as acetoguanamine and benzoguanamine; polyamines such as diaminodiphenylmethane, m-phenylenediamine, m-xylenediamine, diaminodiphenylsulfone, dicyandiamide, urea and urea derivatives, melamine and polybasic hydrazides; organic acid salts and/or epoxy adducts thereof; amine complexes of boron trifluoride; triazine derivatives such as ethyldiamino-S-triazine, 2,4-diamino-S-triazine and 2,4-diamino-6-xylyl-S-triazine; amines such as trimethylamine, triethanolamine, N,N-dimethyloctylamine, N-benzyldimethylamine, pyridine, dimethylaminopyridine, N-methylmorpholine, hexa(N-methyl)melamine, 2,4,6-tris(dimethylaminophenol), tetramethylguanidine and m-aminophenol; polyphenols such as polyvinylphenol, polyvinylphenol bromide, phenol novolac and alkylphenol novolac; organic phosphines such as tributylphosphine, triphenylphosphine and tris-2-cyanoethylphosphine; phosphonium salts such as tri-n-butyl(2,5-dihydroxyphenyl)phosphonium bromide and hexadecyltributylphosphonium chloride; quaternary ammonium salts such as benzyltrimethylammonium chloride and phenyltributylammonium chloride; polybasic acid anhydrides; photocationic polymerization catalysts such as diphenyliodonium tetrafluoroborate, triphenylsulfonium hexafluoroantimonate and 2,4,6-triphenylthiopyrylium hexafluorophosphate; styrene-maleic anhydride resins; equimolar reactants of phenylisocyanate and dimethylamine, equimolar reactants of organic polyisocyanates such as tolylene diisocyanate and isophorone diisocyanate and dimethylamine, metal catalysts and the like. Among these, imidazole and imidazole derivatives are preferably used from the viewpoints of achieving low surface roughness and simultaneously providing high levels of plating adhesion and heat resistance.

Although the curing accelerator is not essential, when it is particularly desired to accelerate the curing reaction, it can be used in an amount of preferably 0.1 to 2.0 % by mass based on the total amount of the (A) epoxy resin and the (B) polyarylate compound having a bisphenol structure and an ester group. The curing accelerator may be used alone or in combination of two or more.

### [(D) Solvent]

The resin layer constituting the laminated structure according to the present invention comprises (D) a solvent. By comprising the (D) solvent together with the (A) epoxy resin, the (B) polyarylate compound having a bisphenol structure and an ester group, and the predetermined proportion of the inorganic filler, it becomes easy to form a resin layer having a mass loss rate of 3.0 % by mass or less. As described above, the (D) solvent makes it easy to adjust the mass loss rate, but it also serves to adjust the viscosity for preparing a curable resin composition for forming a resin layer and for applying the curable resin composition to the first film. The solvent is not particularly limited, and examples thereof include ketones, aromatic hydrocarbons, glycol ethers, glycol ether acetates, esters, alcohols, aliphatic hydrocarbons, petroleum-based solvents and the like. More specifically, ketones such as methyl ethyl ketone, cyclohexanone, methyl butyl ketone and methyl isobutyl ketone; aromatic hydrocarbons such as toluene, xylene and tetramethylbenzene; glycol ethers such as cellosolve, methyl cellosolve, butyl cellosolve, carbitol, methyl carbitol, butyl carbitol, ethylene glycol monomethyl ether, ethylene glycol monoethyl ether, ethylene glycol monobutyl ether, propylene glycol monomethyl ether, dipropylene glycol monomethyl ether, dipropylene glycol diethyl ether and triethylene glycol monoethyl ether; esters such as ethyl acetate, butyl acetate, isobutyl acetate, ethylene glycol monoethyl ether acetate, dipropylene glycol methyl ether acetate, propylene glycol methyl ether acetate, propylene glycol ethyl ether acetate and propylene glycol butyl ether acetate; alcohols such as ethanol, propanol, 2-methoxypropanol, n-butanol, isobutyl alcohol, isopentyl alcohol, ethylene glycol and propylene glycol; aliphatic hydrocarbons such as octane and decane; petroleum-based solvents such as petroleum ether, petroleum naphtha, hydrogenated petroleum naphtha and solvent naphtha, as well as N,N-dimethylformamide (DMF), tetrachloroethylene and turpentine. In addition, organic solvents such as Swazol 1000 and Swazol 1500 manufactured by Maruzen Petrochemical Co., Ltd., Solvent #100 and Solvent #150 manufactured by Sankyo Chemical Co., Ltd., Shellsol A100 and Shellsol A150 manufactured by Shell Chemicals Japan Ltd., and Ipzol No. 100 and Ipzol No. 150 manufactured by Idemitsu Kosan Co., Ltd. may be used. These (D) solvents may be used alone or in combination of two or more.

The content of the (D) solvent in the resin layer is not particularly limited, and may be in the range of 0.1 to 10.0 % by mass.

### [Other components]

In addition to the above-mentioned components, the resin layer constituting the laminated structure according to the present invention may comprise known additives such as thermosetting components such as oxetane compounds and episulfide resins, organic fillers such as silicon powder, fluorine powder and nylon powder, colorants such as phthalocyanine blue, phthalocyanine green, iodine green, disazo yellow, crystal violet, titanium oxide, carbon black and naphthalene black, thickeners such as asbestos, orben, bentone and finely powdered silica, antifoaming agents and/or leveling agents such as silicone-based, fluorine-based and polymer-based agents, and adhesion imparting agents such as thiazole-based, triazole-based and silane coupling agents.

### <Method of producing laminated structure>

The laminated structure of the present invention can be produced by applying the curable resin composition comprising, as essential components, (A) an epoxy resin, (B) a polyarylate compound having a bisphenol structure and an ester group, a predetermined amount of (C) an inorganic filler and (D) a solvent to one side of a first film in a uniform thickness using a comma coater, blade coater, lip coater, rod coater, squeeze coater, reverse coater, transfer roll coater, gravure coater, spray coater or the like to form a coating film, and then drying the coating film at a temperature of 60 to 180 °C. for 1 to 30 minutes to form a resin layer. The thickness of the resin layer is usually 1 to 200 µm, preferably 10 to 150 µm.

Examples of the first film include metal foils (for example, copper foils), carrier films and the like. The carrier film is not particularly limited, and may be, for example, a polyester film such as polyethylene terephthalate and polyethylene naphthalate, a polyimide film, a polyamideimide film, a polyethylene film, a polytetrafluoroethylene film, a polypropylene film, a polystyrene film and the like. In addition, the above-mentioned films may be uniaxially or biaxially stretched films from the viewpoint of improving mechanical strength.

The surface of the first film facing the resin layer is preferably subjected to a release treatment. The release treatment can be performed by applying a release agent to the surface of the first film to form a release layer. As the release agent, a known silicone resin or non-silicone resin can be used, but in the present invention, a non-silicone resin can be preferably used. By using a non-silicone resin and the (B) polyarylate compound having a bisphenol structure and an ester group in combination, it is possible to suppress repelling and sink marks when a curable resin composition is applied to the surface (resin layer side) of the first film. It should be noted that non-silicone resins do not include waxes. Conventionally, a first film using a silicone resin as a release agent has been preferably used because of its excellent peelability, but when a curable resin composition comprising the (B) polyarylate compound having a bisphenol structure and an ester group is applied to a first film that has been release-treated with a silicone resin, repelling and sink marks are likely to occur. In contrast, a first film that has been release-treated with a non-silicone resin can suppress repelling and sink marks when a curable resin composition comprising the (B) polyarylate compound having a bisphenol structure and an ester group is applied. Furthermore, when a silicone resin is used as a release agent, the (B) polyarylate compound having a bisphenol structure and an ester group may absorb the silicone resin, resulting in a risk of reduced adhesion between the cured product and the plating. However, when the first film is subjected to release treatment with a non-silicone resin, the adhesion between the cured product and the plating can be improved.

The laminated structure may have a second film releasably provided on the surface of the resin layer for the purpose of preventing dust from adhering to the surface of the resin layer. The second film may be the same as the first film, and may be, for example, a polyester film, a polyethylene film, a polypropylene film and the like. The term "releasable" means that when the second film is peeled from the resin layer, the adhesive strength between the resin layer and the second film is smaller than the adhesive strength between the resin layer and the first film, and the surface of the second film may be subjected to a release treatment, for example.

The laminated structure of the present invention can be suitably used as a resin-coated copper foil (RCC: Resin-Coated-Copper) compatible with the modified semi-additive process (MSAP) or a build-up film compatible with the semi-additive process (SAP).

### <Cured product and electronic parts>

The cured product of the present invention can be obtained by curing the resin layer of the laminated structure. For example, the cured product of the resin layer can be obtained by heating the resin layer of the laminated structure at a temperature of 150 to 250 °C. for 30 to 90 minutes to thermally cure the resin component.

Examples of substrate onto which the resin layer of the laminated structure is laminated include printed wiring boards and flexible printed wiring boards on which circuits have been formed in advance using copper and the like, and copper-clad laminates of all grades (FR-4 and the like) which use materials such as copper-clad laminates for high-frequency circuits made of materials such as paper phenol, paper epoxy, glass cloth epoxy, glass polyimide, glass cloth/non-woven cloth epoxy, glass cloth/paper epoxy, synthetic fiber epoxy, fluororesin/polyethylene/polyphenylene ether, polyphenylene oxide/cyanate and the like, as well as metal substrates, polyimide films, polyethylene terephthalate films, polyethylene naphthalate (PEN) films, glass substrates, ceramic substrates, wafer plates and the like.

It is preferable to laminate the resin layer of the laminated structure on the substrate under pressure and heat using a vacuum laminator and the like. By using such a vacuum laminator, even if the circuit board surface is uneven, the resin layer adheres to the circuit board, so that no air bubbles are mixed in and the filling of the recesses on the substrate surface is improved. After laminating the resin layer of the laminated structure on the substrate, the resin component is thermally cured by heating at a temperature of 150 to 250 °C. for 30 to 90 minutes to obtain a cured product.

According to the laminated structure of the present invention, it is possible to obtain a cured product having a surface roughness of less than 0.30 µm, or even less than 0.20 µm, a peel strength from plating of 3.0 N/cm or more, or even 3.5 N/cm or more, and a glass transition temperature of 180 °C. or more, or even 190 °C. or more.

The cured product obtained by using the laminated structure of the present invention can be used as an insulating layer for electronic components, and can be preferably used as an interlayer insulating film for a multilayer printed wiring board. The cured product may also be used as a passivation film for a semiconductor, a protective film for a semiconductor element, an interlayer insulating film for a semiconductor, a solder resist for a printed wiring board, or a coverlay for a flexible printed wiring board.

Examples of the electronic component include printed wiring boards, semiconductors, as well as passive components such as inductors. Further, examples of the electronic component for high frequency applications include substrates for millimeter wave radars and millimeter wave sensors for autonomous driving, motherboards for mobile devices compatible with high speed communication, SLPs (Substrate-Like PCBs) in which circuits are formed by the modified semi-additive process (MSAP) method, application processors (APs) for mobile devices and personal computers, highly multi-layer substrates for base station servers and routers, substrates for antennas and the like.

### [Examples]

Hereinafter, the present invention will be described in more detail with reference to Examples, but the present invention is not limited to these Examples. In the following, "part(s)" and "%" are both on mass basis unless otherwise specified.

### <Preparation of curable resin composition>

Respective components shown in the following Table 1 were mixed and thoroughly stirred, and then kneaded and mixed using a three-roll mill to prepare respective curable resin compositions shown in the same Table. Each value in Table indicates parts by mass or % by mass calculated as the solid amount.

It should be noted that details of each component *1 to *9 in the following Table 1 are described as follows.
*1: Bisphenol A type and bisphenol F type mixed epoxy resin (solid amount 100 % by mass), manufactured by Nippon Steel Chemical & Material Co., Ltd., epoxy equivalent (equivalent amount derived from the content of epoxy groups) 165 g/eq.
*2: Biphenyl novolac type epoxy resin (solid amount 100 % by mass) manufactured by Nippon Kayaku Co., Ltd., epoxy equivalent (equivalent amount derived from the content of epoxy groups) 290 g/eq.
*3: Unifiner (registered trademark) W-575 (solid amount 100 % by mass), manufactured by Unitika Ltd., functional group equivalent (equivalent amount derived from the content of ester groups and phenolic hydroxyl groups) 220 g/eq., number average molecular weight 3,200, phenolic hydroxyl group end-blocked type.
*4: Unifiner (registered trademark) V-575 (solid amount 100 % by mass), manufactured by Unitika Ltd., functional group equivalent (equivalent amount derived from the content of ester groups and phenolic hydroxyl groups) 210 g/eq, number average molecular weight 3,300, phenolic hydroxyl group end-blocked type.
*5: Active ester compound having a dicyclopentadiene skeleton (solid amount 65 % by mass), manufactured by DIC Corporation, ester equivalent 223 g/eq.
*6: Active ester compound having a naphthalene skeleton (solid amount 62 % by mass), manufactured by DIC Corporation, ester equivalent 230 g/eq.
*7: Phenylaminosilane-treated spherical silica (solid amount 100 % by mass), manufactured by Admatechs Co., Ltd., average particle size (D50) 0.5 µm.
*8: Phenoxy resin having a bisphenol skeleton (solid amount 30 % by mass), manufactured by Mitsubishi Chemical Corporation, epoxy equivalent 13,000 g/eq.
*9: 2-ethyl-4-methylimidazole manufactured by Shikoku Kasei Co., Ltd.

### <Preparation of laminated structure>

Using a film applicator, each of the curable resin compositions obtained as described above was applied to a release-treated surface of a release-treated polyethylene terephthalate film (manufactured by Toyobo Co., Ltd., product number: TN-200, a film having a non-silicone resin release layer on one side) to form a coating film. Then, the coating film was dried in a hot air circulation drying oven under the drying conditions shown in Table 2 to form a resin layer with a thickness of 40 µm, and thereby a laminated structure was produced.

### <Measurement of mass loss rate>

A copper foil having a thickness of 18 µm (manufactured by Furukawa Electric Co., Ltd., F2-WS) cut to 150 mm×90 mm was heated on a hot plate at 80 °C., and the resin layer of each of the laminated structures was laminated to the shiny surface of the copper foil within 10 seconds. Then, the temperature was immediately returned to room temperature, and the polyethylene terephthalate film was peeled off.

The mass of the obtained copper foil with a resin layer was measured, and then the copper foil with a resin layer was heated at a temperature of 100 °C. under atmospheric pressure for 20 minutes, and then allowed to cool at room temperature for 20 minutes, after which the mass of the copper foil with a resin layer was measured.

The mass loss rate is calculated by the following formula: 100 × (Mass of resin layer before heating - Mass of resin layer after heating)/Mass of resin layer before heating.

The calculation results are shown in Table 2.

### <Evaluation of surface roughness of cured product>

The resin layer of each laminated structure of Examples and Comparative Examples was laminated on both sides of a copper-clad laminate (CCL-HL832NX, manufactured by Mitsubishi Gas Chemical Co., Ltd., copper thickness of 0.4 mm) using a batch-type vacuum pressure laminator (MVLP-500, manufactured by Meiki Seisakusho Co., Ltd.). The lamination was performed by reducing the pressure for 30 seconds to 13 hPa or less, and then pressing at a pressure of 0.5 MPa at 110 °C for 30 seconds.

The resin layer was then cured by heating at 150 °C. for 30 minutes in a hot air circulating drying oven, and the polyethylene terephthalate film was then peeled off from the surface of the cured product to obtain a laminated structure in which the cured products were formed on both sides of the copper-clad laminate.

The obtained laminated structure was then immersed in a commercially available wet permanganate desmear (manufactured by Atotech Japan Co., Ltd., Swelling Dip Securigant P) at 60 °C. for 10 minutes (swelling treatment), and then immersed in potassium permanganate (manufactured by Atotech Japan Co., Ltd., Concentrate Compact CP) at 80 °C. for 20 minutes for roughening treatment. It was then immersed in a neutralizing solution (manufactured by Atotech Japan Co., Ltd., Reduction Securigant P500) at 40 °C. for 5 minutes (reduction treatment), and then dried at 100 °C. for 30 minutes in a hot air circulation drying oven.

In order to evaluate the surface condition of the cured product after the roughening treatment, the surface roughness Ra was measured using a laser microscope (VK-8500, manufactured by Keyence Corporation, magnification: 100 times). The evaluation of the surface roughness was performed according to the following criteria.
⊚ : Less than 0.20 µm
○ : Good: 0.20 µm or more and less than 0.30 µm
△ : 0.30 µm or more and less than 0.35 µm
× : 0.35 µm or more

The evaluation results are shown in Table 2 below.

### <Evaluation of plating adhesion>

Test substrates for evaluating plating adhesion were prepared according to the following procedure.
(1) Both sides of a copper-clad laminate (CCL-HL832NX, manufactured by Mitsubishi Gas Chemical Co., Ltd., copper thickness of 0.4 mm, length of 150 mm, width of 100 mm) were immersed in CZ8100 manufactured by MEC Co., Ltd. to perform a roughening treatment of the copper surface (etching amount: about 1 µm).
(2) Next, the resin layer of each laminated structure of Examples and Comparative Examples was laminated on both sides of the copper-clad laminate that had been roughened as described above, using a batch-type vacuum pressure laminator (MVLP-500, manufactured by Meiki Seisakusho Co., Ltd.). The lamination was performed by reducing the pressure for 30 seconds to 13 hPa or less, and then pressing at a pressure of 0.5 MPa at 110 ° C. for 30 seconds.
(3) Subsequently, the resin layer was cured by heating at 150 °C. for 30 minutes in a hot air circulation drying oven, and then the polyethylene terephthalate film was peeled off from the surface of the cured product to obtain a laminated structure in which the cured products were formed on both sides of the copper-clad laminate.
(4) The obtained laminated structure was immersed in a commercially available wet permanganate desmear (manufactured by Atotech Japan Co., Ltd., Swelling Dip Securigant P) at 60 °C. for 10 minutes (swelling treatment), and then immersed in potassium permanganate (manufactured by Atotech Japan Co., Ltd., Concentrate Compact CP) at 80 °C. for 20 minutes (roughening treatment), and then immersed in a neutralizing solution (manufactured by Atotech Japan Co., Ltd., Reduction Securigant P500) at 40 °C. for 5 minutes (reduction treatment), and then dried at 100 °C. for 30 minutes in a hot air circulation drying oven.
(5) Next, the roughened cured product was subjected to electroless copper plating (cleaner 40 °C for 5 minutes, pre-dip 25 °C for 2 minutes, activator 40 °C for 5 minutes, reducer 35 °C for 3 minutes, accelerator 25 °C for 1 minute, Thru-cup Ver2, Uemura Kogyo Co., Ltd., 36 °C for 20 minutes). The cured product on which the electroless copper plating layer was formed was heated in a hot air circulation drying oven at 150 °C for 30 minutes, and then further subjected to copper sulfate electroplating to form an electrolytic copper plating layer having a thickness of 25 ± 5 µm on the cured product. The cured product was then heated at 190 to 200 °C for 60 minutes to prepare a test substrate.

A incision having a width of 10 mm and a length of 60 mm was made in the copper plating layer of the test substrate thus obtained, and the copper plating layer at both ends in the width direction was removed. One end in the length direction of the remaining copper plating layer was peeled off and clamped with a gripper, and the peel strength (N/cm) was measured when the copper plating layer was peeled off over a length of 35 mm at an angle of 90 degrees at a speed of 50 mm/min using a tabletop tensile tester (manufactured by Shimadzu Corporation, AG-X). The plating adhesion was evaluated according to the following criteria.
⊚ : 3.5 N/cm or more
○ : 3.0 N/cm or more and less than 3.5 N/cm
△ : 2.5 N/cm or more and less than 3.0 N/cm
× : Less than 2.5 N/cm

The evaluation results are shown in Table 2 below.

### <Evaluation of heat resistance>

Each curable resin composition was applied onto the shiny surface of copper foil (manufactured by Furukawa Electric Co., Ltd., F2-WS, 18 µm thick) using a film applicator, dried in a hot air circulation drying oven at 90 °C. for 10 minutes, and then cured at 200 °C. for 60 minutes to obtain a cured product. The copper foil was then peeled off from the surface of the cured product to produce a film-like cured product with a thickness of approximately 40 µm.

The cured product obtained as described above was cut into a measurement size (3 mm x 10 mm), and the glass transition temperature (Tg) was measured using a TMA Q400EM manufactured by TA Instruments. The glass transition temperature was measured twice by heating from room temperature to 300 °C at a heating rate of 10 °C/min, cooling to room temperature, and repeating heating again under the same conditions, and the temperature (Tg) at the intersection of two tangents with different linear thermal expansion coefficients in the second measurement was recorded. The evaluation of the heat resistance of the cured product was performed according to the following criteria.
⊚ : Tg is 190 °C. or higher
○ : Tg is 180 °C. or higher and less than 190 °C.
× : Tg is less than 180 °C.

The evaluation results are shown in Table 2 below.

**[Table 1]**

| Components | | Type of curable resion composition | | | | | | | | | | |
|---|---|---|---|---|---|---|---|---|---|---|---|---|
| | | 1 | 2 | 3 | 4 | 5 | 6 | 7 | 8 | 9 | 10 | 11 |
| Component (A) | ZX-1059^{*1} | 20 | 20 | 20 | 20 | 20 | 20 | 20 | 20 | 20 | 20 | 20 |
| | NC-3000H^{*2} | 80 | 80 | 80 | 80 | 80 | 80 | 80 | 80 | 80 | 80 | 80 |
| Component (B) | W-575^{*3} | 87 | 87 | - | 87 | 87 | 87 | - | - | 87 | 87 | - |
| | V-575^{*4} | - | - | 83 | - | - | - | - | - | - | - | - |
| Component (B') | HPC-8000-65T^{*5} | - | - | - | - | - | - | 89 | - | - | - | - |
| | HPC-8150-62T^{*6} | - | - | - | - | - | - | - | 91 | - | - | 91 |
| Component (C) | SO-C2^{*7} | 483 | 483 | 473 | 138 | 828 | 483 | 486 | 493 | 111 | 1173 | 108 |
| Phenoxy resin | YX6954BH30^{*8} | 19 | 19 | 18 | 19 | 19 | 19 | 19 | 19 | 19 | 19 | 25 |
| Curing accelerator | 2E4MZ^{*9} | 0.9 | 0.9 | 0.9 | 0.9 | 0.9 | 0.9 | 0.9 | 1.0 | 0.9 | 0.9 | 1.2 |
| Component (D) | Cyclohexanone | 360 | 225 | 401 | 212 | 508 | 469 | 230 | 234 | 201 | 656 | 75 |
| | Methylethylketone | 22 | 273 | 21 | 22 | 22 | 22 | 48 | 56 | 22 | 22 | 29 |
| Blending ratio of Component (C) (% by mass) | | 70% | 70% | 70% | 40% | 80% | 70% | 70% | 70% | 35% | 85% | 33% |

**[Table 2]**

| | | Example | | | | | | | Comparative Example | | | | | |
|---|---|---|---|---|---|---|---|---|---|---|---|---|---|---|
| | | 1 | 2 | 3 | 4 | 5 | 6 | 7 | 1 | 2 | 3 | 4 | 5 | 6 |
| Type of curable resin composition | | 1 | 1 | 1 | 2 | 3 | 4 | 5 | 6 | 7 | 8 | 9 | 10 | 11 |
| Conditions for forming resin layer | Drying temperature (°C) | 100 | 110 | 90 | 100 | 100 | 100 | 100 | 100 | 100 | 100 | 100 | 100 | 90 |
| | Drying time (min) | 4 | 4 | 4 | 4 | 4 | 4 | 4 | 4 | 4 | 4 | 4 | 4 | 2 |
| Mass loss rate after heating resin layer for the predetermined conditions (%) | | 2.0 | 1.3 | 2.5 | 1.1 | 2.0 | 1.3 | 2.2 | 3.5 | 2.0 | 2.0 | 2.0 | 2.0 | 3.5 |
| Surface roughness of cured product | | ⊚ | ⊚ | ○ | ⊚ | ○ | ⊚ | ○ | × | ○ | ○ | ⊚ | Δ | ○ |
| Plating adhesion of cured product | | ⊚ | ⊚ | ○ | ⊚ | ⊚ | ⊚ | ○ | × | △ | △ | × | × | × |
| Heat resistance of cured product | | ○ | ○ | ○ | ○ | ⊚ | ○ | ○ | ○ | × | × | ○ | ○ | × |

As is clear from Tables 1 and 2, among the laminated structures in which a resin layer is formed using a curable resin composition comprising (A) an epoxy resin, (B) a polyarylate compound having a bisphenol structure and an ester group, a predetermined amount of (C) an inorganic filler, and (D) a solvent, the laminated structures in which the mass loss rate after heating the resin layer under predetermined conditions is 3.0 % by mass or less (Examples 1 to 7) can provide cured products having a low surface roughness, excellent plating adhesion, and excellent heat resistance.

In contrast, among the laminated structures in which a resin layer is formed using a curable resin composition comprising (A) an epoxy resin, (B) a polyarylate compound having a bisphenol structure and an ester group, a predetermined amount of (C) an inorganic filler, and (D) a solvent, the laminated structure in which the mass loss rate after heating the resin layer under predetermined conditions is more than 3.0 % by mass (Comparative Example 1) can provide a cured product having excellent heat resistance but insufficient surface roughness and plating adhesion.

Furthermore, even if the mass loss rate after heating the resin layer under the predetermined conditions is 3.0 mass or less, the laminated structures in which the resin layer does not comprise the (B) polyarylate compound having a bisphenol structure and an ester group (Comparative Examples 2 and 3) provide a cured product having a low surface roughness but insufficient plating adhesion and heat resistance.

Furthermore, even if the mass loss rate after heating the resin layer under the predetermined conditions is 3.0 mass or less, the laminated structure in which the content of the (C) inorganic filler comprised in the resin layer is less than 38 % by mass on a solid amount basis (Comparative Example 4) provides a cured product having a low surface roughness and excellent heat resistance but insufficient plating adhesion.

Furthermore, even if the mass loss rate after heating the resin layer under the predetermined conditions is 3.0 mass or less, the laminated structure in which the content of the (C) inorganic filler comprised in the resin layer is more than 82 % by mass on a solid amount basis (Comparative Example 5) provides a cured product having excellent heat resistance but insufficient surface roughness and plating adhesion.

Furthermore, the laminated structure in which the resin layer does not comprise the (B) polyarylate compound having a bisphenol structure and an ester group, and the content of the (C) inorganic filler is less than 38 % by mass on a solid amount basis (Comparative Example 6) provides a cured product having a low surface roughness but insufficient plating adhesion and heat resistance.

## Claims

1. A laminated structure comprising a first film and a resin layer provided on the first film, wherein
the resin layer comprises
(A) an epoxy resin;
(B) a polyarylate compound having a bisphenol structure and an ester group;
(C) an inorganic filler; and
(D) a solvent;
the (C) inorganic filler is comprised in the resin layer in an amount of 38 to 82 % by mass on a solid amount basis, and
the resin layer has a mass loss rate of 3.0 % by mass or less after heating the resin layer at a temperature of 100 °C. under atmospheric pressure for 20 minutes.

2. The laminated structure according to claim 1, wherein the resin layer has a mass loss rate of 2.0 % by mass or less after heating the resin layer at a temperature of 100 °C. for 20 minutes.

3. The laminated structure according to claim 1, wherein the resin layer is substantially free of a photopolymerization initiator and a photopolymerizable compound.

4. A method for producing the laminated structure according to any one of claims 1 to 3, which comprises:
a step of preparing a curable resin composition comprising (A) an epoxy resin, (B) a polyarylate compound having a bisphenol structure and an ester group, (C) an inorganic filler and (D) a solvent, wherein the inorganic filler is comprised in the resin layer in an amount of 38 to 82 % by mass on a solid amount basis;
a step of applying the curable resin composition to one surface of a first film to form a coating film; and
a step of drying the coating film at a temperature of 60 to 180 °C. for 1 to 30 minutes to form a resin layer.

5. A cured product of the resin layer of the laminated structure according to any one of claims 1 to 3.

6. An electronic part comprising the cured product according to claim 5.
